# EUROPÄISCHE PATENTSCHRIFT

(11) **EP 1 267 418 B1**
(45) Veröffentlichungstag und Bekanntmachung des Hinweises auf die Patenterteilung: **17.03.2010**
(21) Anmeldenummer: 02012856.7
(22) Anmeldetag: 11.06.2002
(51) Int. Cl.: H01L 31/042, H01L 31/048

(54) **Solarzellen-Montagemodul**
Mounting module for solar cells
Module de montage pour cellules solaires

(30) Priorität: 11.06.2001 DE 10128237
(43) Veröffentlichungstag der Anmeldung: 18.12.2002
(73) Patentinhaber: Sika-Trocal GmbH, 53840 Troisdorf (DE)
(72) Erfinder: Klaar, Karlo, 53844 Troisdorf (DE); Stelzer, Harry, 53840 Troisdorf-FWH (DE); Slongo, Mario, Dr., 1712 Tafers (CH); Frettlöh, Randolf, 57520 Neunkhausen (DE); Kröger, Bernd, 36132 Arzell (DE)
(74) Vertreter: Sika Patent Attorneys

(56) Entgegenhaltungen:
- EP-A1- 1 079 442
- EP-A2- 0 874 404
- EP-A2- 0 903 790
- EP-A2- 0 981 167
- WO-A-01/18881
- WO-A-94/00650
- DE-A1- 19 828 462
- JP-A- 60 257 183
- US-A- 4 860 509

## Beschreibung

Die Erfindung betrifft ein Solarzellen-Montagemodul mit wenigstens einer Solarzelle bzw. wenigstens einem Solarzellenmodul sowie einem Blechprofil-Tragwerk sowie die Verwendung eines entsprechenden Bleches als Träger für Solarzellen bzw. Solarzellenmodule.

### Stand der Technik

Aus der DE 198 28 462 A1 ist eine Dachabdichtung aus Dachbahnen zum Schutz eines Bauwerkes gegen Witterungseinflüsse bekannt, die einseitig Solarzellenmodule zur Engergiegewinnung aufweist. Die einzelnen Photovoltaik-Module sind jeweils wasserdicht und hochpolymer verkapselt und kraftschlüssig mit der Dachbahn verbunden.

Aus der EP 0 874 404 A2 sind Solarzellenmodule und Verfahren zu deren Herstellung bekannt. Dabei sind die Module aus mehreren Lagen hergestellt und können auf ihrer Rückseite ein Trägerelement aus einem beschichteten galvanisierten Blech aufweisen, wobei die Beschichtung aus einer polyesterbasierenden Farbe besteht.

Ein wesentlicher Nachteil dieser Konstruktion ist es, daß die Solarzellenmodule nicht gegenüber der Sonne ausgerichtet werden können und damit der Wirkungsgrad der Module nicht optimal ist. Ein weiterer Nachteil dieser bekannten Technik ist es, daß sich die Module bei starker Sonneneinstrahlung stark aufheizen können, da rückseitig die Wärme nicht abgeführt werden kann. Die Aufheizung der Module wiederum führt zu vermindertem Wirkungsgrad und verringerter Lebensdauer.

### Aufgabe

Aufgabe der vorliegenden Erfindung ist es daher, die Montage von Solarzellenmodulen zu vereinfachen und zu optimieren, ohne daß die o. gen. Nachteile dabei auftreten.

### Darstellung der Erfindung

Die Erfindung löst diese Aufgabe durch die Verwendung eines wenigstens einseitig mit einer Kunststoff-Folie einer Dicke von 0,25 bis 2 mm kaschierten Bleches als Träger für Solarzellen bzw. Solarzellenmodule. Als Kunststoff-Folie kann eine Dachdichtungsbahn eingesetzt werden. Die Kunststoff-Folie für die Kaschierung des Trägerbleches besteht überwiegend aus einem Polymer, das aufgebaut ist aus den Monomeren Ethylen und wenigstens einem Comonomer, welches aus der Gruppe bestehend aus Vinylestern einer C2- bis C3- Alkancarbonsäure und C1- bis C4- Alkylestern der Acrylsäure ausgewählt ist.

Folienbleche mit einer derartigen Kunststoff-Folie sind an sich bekannt und werden im Randbereich von Flachdächern verwendet.

Ein Solarzellen-Montagemodul gemäß der Erfindung besteht bevorzugt aus einem Blechprofil für das Tragwerk, das wenigstens einseitig mit einer Folie aus dem obengenannten Polymer kaschiert ist. Die Solarzellen werden wiederum bevorzugt in eine Polymer-Folie eingeschweißt, wobei für die Vorder- und Rückseite ggf. unterschiedliche Polymere verwendet werden können, beispielsweise an der Oberseite eine besonders Schmutz- und wasserabweisende Folie auf Basis von Teflon-Material, während die Unterseite bevorzugt aus einem Polymer besteht, das verschweißbar ist mit der Folienbeschichtung des Blechprofil-Tragwerkes.

Das Blechprofil-Tragwerk weist - im Querschnitt betrachtet - bevorzugt einen ersten nach außen weisenden Befestigungsschenkel, einen zweiten nach außen weisenden Befestigungsschenkel, einen etwa im Winkel von 90° bis 135° zu dem ersten Befestigungsschenkel verlaufenden Verbindungsschenkel und einem im Winkel von 110° bis 160° zum zweiten nach außen weisenden Befestigungsschenkel verlaufenden Tragschenkel auf. Auf diesen schräg verlaufenden Tragschenkel werden die Solarzellen bzw. Solarzellenmodule bevorzugt aufkaschiert. Ggf. können die die Solarzellen bzw. Solarzellenmodule auch mit dem Tragschenkel verklebt werden.

Die Kaschierung der Solarzellen bzw. Solarzellenmodule erfolgt bevorzugt durch Warmgasschweißen, wobei es ausreicht, die Module im Randbereich mit dem folienkaschierten Blech-Tragwerk zu verbinden. Warmgasschweißen ist eine dem Durchschnittsfachmann geläufige Fügetechnik und eignet sich überraschenderweise auch zum Verbinden von Solarzellenmodulen, obgleich diese relativ temperaturempfindlich sind. Ggf. können die Solarzellenmodule jedoch auch beispielsweise mittels Lösungsmittel-Schweißung oder durch Klebung mit dem folienkaschierten Blech-Tragwerk verbunden werden.

Es reicht aus, wenn die Polymer-Folie für die Kaschierung des Trägerbleches eine Dicke vom ca. 0,25 mm aufweist. Bevorzugt ist die Dicke max. 2 mm, da größere Dicken keine Vorteile mehr bewirken.

Die Folien-Kaschierung des Blechprofil-Tragwerkes ermöglicht nicht nur eine einfache Aufkaschierung der Solarzellenmodule, sondern insbesondere auch eine einfache und kostensparende Montage des Blechprofil-Tragwerkes auf beispielsweise Flachdächern.

Es ist besonders vorteilhaft, wenn dieses mit einer Dachdichtungsbahn versehen ist, die wiederum mit der Folien-Kaschierung des Blechprofil-Tragwerkes verschweißt werden kann.

Eine besonders bevorzugte Möglichkeit, ein solches Blechprofil-Tragwerk auf einem entsprechenden Flachdach zu befestigen, ist im folgenden beschrieben: das Blechprofil-Tragwerk mit den aufkaschierten Solarzellenmodulen wird zunächst in die gewünschte Himmelsrichtung ausgerichtet. Die Befestigung erfolgt durch Aufschweißen eines ca. 10 bis 20 cm breiten Streifens einer Dachdichtungsbahn insbesondere aus dem gleichen Material, wie es für die Kaschierung des Blechprofil-Tragwerkes und die Abdichtung des Flachdaches verwendet wird. Diese bevorzugt mit einer Verstärkungseinlage versehenen Dachbahn-Streifen werden je zur Hälfte ihrer Breite über die nach außen weisenden Tragschenkel des Blechprofil-Tragwerkes und die Dachbahn aufkaschiert, so daß die Kraftübertragung direkt über diese Dachbahn-Streifen erfolgt. Diese Montagemethode ist einerseits äußerst effektiv und andererseits völlig ausreichend in Bezug auf die notwendige Krafteinleitung von Windkräften etc. über die Dachdichtungsbahn in die Dachkonstruktion. Alternativ können die Blechprofil-Tragwerke auch mittels üblicher Schraubtechnik mit der Dachkonstruktion verbunden werden, wobei die Schrauben ggf. mittels aufkaschierter bzw. aufgeschweißter Lappen aus dem Dachdichtungs-Material abgedichtet werden können.

### Kurze Beschreibung der Zeichnung

Die Erfindung wird nachfolgend anhand eines Ausführungsbeispiels sowie der Zeichnung näher erläutert. Es zeigen dabei:
- Fig. 1: ein Solarzellen-Montagemodul, befestigt durch eine Schraubverbindung auf einem Stahl-Trapezblech-Dach,
- Fig. 2: einen Querschnitt durch ein Solarzellen-Montagemodul mit alternativer Befestigungstechnik.

### Wege zur Ausführung der Erfindung

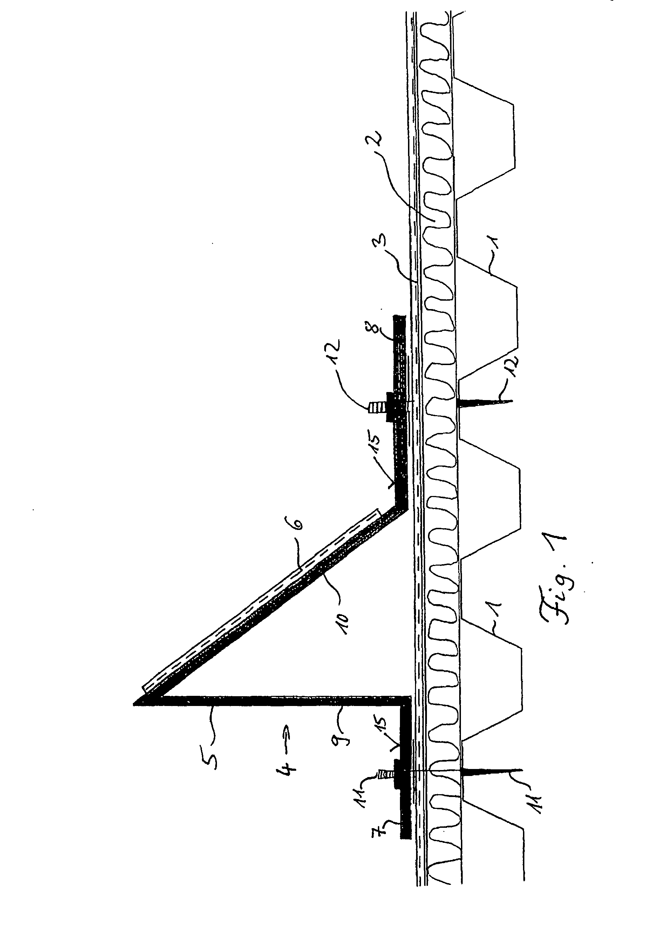

Das Solarzellen-Montagemodul 4 gemäß Fig. 1 besteht aus einem Blechprofil-Tragwerk 5 und dem Solarzellenmodul 6. Das Blechprofil-Tragwerk 5 weist - im Querschnitt betrachtet - die jeweils nach außen weisenden Befestigungsschenkel 7 und 8, den im Winkel von 90° zum ersten Befestigungsschenkel 7 verlaufenden Verbindungsschenkel 9 und einen im Winkel von 135° zum zweiten nach außen weisenden Befestigungsschenkel 8 verlaufenden Tragschenkel 10 auf. Das gesamte Blechprofil-Tragwerk 5 ist einseitig mit einer 0,8 mm starken Kunststoff-Folie 15 kaschiert. Die Kunststoff-Folie 15 besteht zu 30 Gew.-% aus Polyethylen und zu 70 % aus EVA als Bindemittel, zusätzlich enthält die Folie noch Füllstoffe, Pflanzschutzmittel, Stabilisatoren, Farbpigmente etc. in üblichen Beimengungen. Diese Bleche sind unter der Handelsbezeichnung Trocal-Futura-Verbundblech bei der Sika-Trocal GmbH erhältlich. Das Blech-Tragwerk 5 wird durch Kanten aus einem ebenen Blech hergestellt, wobei bezüglich der Winkel grundsätzlich keine Beschränkungen vorliegen, bevorzugt wird jedoch der Winkel zwischen dem Tragschenkel 10 und dem Befestigungsschenkel 8 im Bereich von 110° bis 160° liegen, um eine optimale Ausrichtung zur Sonne zu erreichen. Dementsprechend wird der Winkel zwischen dem nach außen weisenden Befestigungsschenkel 7 und dem Verbindungsschenkel 9 üblicherweise zwischen 90° und 135° betragen.

Auf den Tragschenkel 10 ist das Solarzellenmodul 6 durch Applikation von Wärme und Druck aufkaschiert, wobei das Solarzellenmodul 6 auf seiner Unterseite mit einem Polymeren kaschiert ist, das mit der Kunststoff-Folie 15 des Blechprofil-Tragwerkes 5 kompatibel ist.

In Fig. 1 ist ein erstes Ausführungsbeispiel dargestellt, wobei das Blechprofil-Tragwerk 5 mittels der Schraubverbindungen 11 und 12 am Trapezblech 1 befestigt ist. Die Schrauben 11 und 12 müssen dabei in dem Fachmann bekannter Weise gegenüber der Dachbahn 3 abgedichtet werden, um ein Eindringen von Feuchtigkeit in die Wärmedämmung 2 zu verhindern.

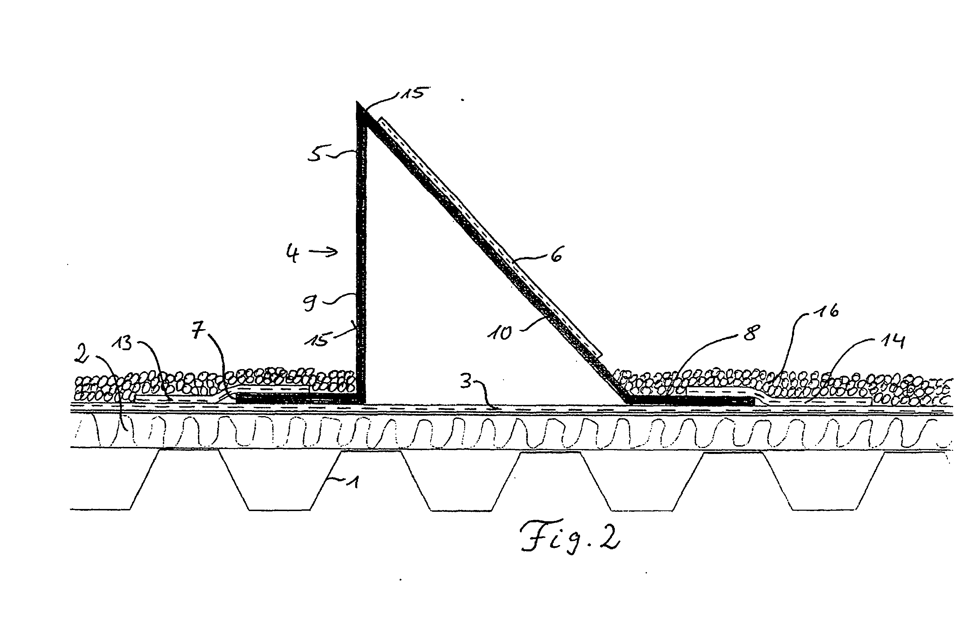

In Fig. 2 ist eine alternative Ausführungsform der Erfindung dargestellt, wobei die Befestigung des Blechprofil-Tragwerkes 5 mittels zweier Streifen 13, 14 aus einer verstärkten Dachbahn aus dem gleichen Kunststoff erfolgt, wie er für die Kaschierung des Blechprofil-Tragwerkes 5 verwendet wird. Diese Ausführungsform der Erfindung ist besonders bevorzugt bei Dächern mit Auflast 16, die also beispielsweise mit Kies beaufschlagt werden.

### Legende

- 1.: Trapezblech
- 2.: Wärmedämmung
- 3.: Dachbahn
- 4.: Solarzellen-Montagemodul
- 5.: Blechprofil-Tragwerk
- 6.: Solarzellenmodul
- 7.: Befestigungsschenkel
- 8.: Befestigungsschenkel
- 9.: Verbindungsschenkel
- 10.: Tragschenkel
- 11.: Schraubverbindung
- 12.: Schraubverbindung
- 13.: Dachbahnstreifen
- 14.: Dachbahnstreifen
- 15.: Kunststoff-Folie
- 16.: Auflast

## Patentansprüche

1. Verwendung eines wenigstens einseitig mit einer Kunststoff-Folie (15) einer Dicke von 0,25 bis 2 mm kaschierten Bleches als Träger für Solarzellen bzw. Solarzellenmodule (6), wobei die Kunststoff-Folie (15) für die Kaschierung des Trägerbleches überwiegend aus einem Polymer besteht, das aufgebaut ist aus dem Monomeren Ethylen und wenigstens einem Comonomer, welches aus der Gruppe bestehend aus Vinylestern einer C2- bis C3-Alkancarbonsäure und C1-bis C4-Alkylestern der Acrylsäure ausgewählt ist.

2. Verwendung nach Anspruch 1, **dadurch gekennzeichnet, dass** als Kunststoff-Folie (15) eine Dachdichtungsbahn eingesetzt wird.

3. Verwendung nach einem der Ansprüche 1 oder 2, **dadurch gekennzeichnet, dass** die Solarzellen bzw. Solarzellenmodule (6) rückseitig mit einer Kunststoffbeschichtung versehen sind, wobei die Kunststoffbeschichtung der Solarzellen bzw. der Solarzellenmodulen (6) verschweissbar ist mit der Kunststoff-Folien-Kaschierung des Trägerbleches.

4. Verwendung nach einem der Ansprüche 1 bis 3, **dadurch gekennzeichnet, dass** die Kaschierung der Solarzellen bzw. der Solarzellenmodule mit der Kunststoff-Folien-Kaschierung des Trägerbleches durch thermisches Verschweissen, insbesondere mittels Warmgasschweissen, erfolgt.

5. Solarzellen-Montagemodul (4) mit wenigstens einer Solarzelle bzw. wenigstens einem Solarzellenmodul (6) sowie einem Blechprofil-Tragwerk (5),
**dadurch gekennzeichnet, dass**
- das Blechprofil für das Tragwerk wenigstens einseitig mit einer Kunststoff-Folie (15) kaschiert ist,
- wobei die Kunststoff-Folie (15) überwiegend aus einem Polymer besteht, das aufgebaut ist aus dem Monomeren Ethylen und wenigstens einem Comonomer, welches aus der Gruppe bestehend aus Vinylestern einer C2- bis C3-Alkancarbonsäure und C1- bis C4-Alkylestern der Acrylsäure ausgewählt ist,
- dass die Kunststoff-Folie (15) eine Dicke von 0,25 bis 2 mm aufweist,
- und wobei die Solarzelle bzw. das Solarzellenmodul auf die Kunststoff-Folie (15) aus dem Polymer aufkaschiert ist.

6. Solarzellen-Montagemodul (4) nach Anspruch 5, **dadurch gekennzeichnet, dass** Blechprofil-Tragwerk (5) - im Querschnitt betrachtet -
- einen ersten nach aussen weisenden Befestigungsschenkel (7),
- einen zweiten nach aussen weisenden Befestigungsschenkel (8),
- einen im Winkel von 90° bis 135° zu dem ersten Befestigungsschenkel verlaufenden Verbindungsschenkel (9) und
- einen im Winkel von 110° bis 160° zum zweiten nach aussen weisenden Befestigungsschenkel (8) verlaufenden Tragschenkel (10)
aufweist.

## Claims

1. Use of a metal sheet, laminated at least on one side with a plastics film (15) of a thickness of 0.25 to 2 mm, as a carrier for solar cells or solar cell modules (6), wherein the plastics film (15) for the lamination of the carrier sheet consists predominantly of a polymer that is made up of the monomer ethylene and at least one co-monomer which is selected from the group comprising vinyl esters of a C2 to C3 alkane carboxylic acid and C1 to C4 alkyl esters of acrylic acid.

2. Use according to Claim 1, **characterized in that** a waterproofing roof membrane is used as the plastics film (15).

3. Use according to either of Claims 1 and 2, **characterized in that** the solar cells or solar cell modules (6) are provided on the rear side with a plastics coating, the plastics coating of the solar cells or the solar cell modules (6) being weldable to the plastics film lamination of the carrier sheet.

4. Use according to one of Claims 1 to 3, **characterized in that** the lamination of the solar cells or the solar cell modules with the plastics film lamination of the carrier sheet takes place by thermal welding, in particular by means of hot-gas welding.

5. Solar cell mounting module (4) with at least one solar cell or at least one solar cell module (6) and a sheet-metal profile supporting structure (5), **characterized in that**
- the sheet-metal profile for the supporting structure is laminated at least on one side with a plastics film (15),
- the plastics film (15) consists predominantly of a polymer that is made up of the monomer ethylene and at least one co-monomer which is selected from the group comprising vinyl esters of a C2 to C3 alkane carboxylic acid and C1 to C4 alkyl esters of acrylic acid,
- the plastics film (15) has a thickness of 0.25 to 2 mm,
- and the solar cell or the solar cell module is laminated on the plastics film (15) of the polymer.

6. Solar cell mounting module (4) according to Claim 5, **characterized in that** the sheet-metal profile supporting structure (5) has - when considered in cross section -
- a first, outwardly facing fastening leg (7),
- a second, outwardly facing fastening leg (8),
- a connecting leg (9), running at an angle of 90° to 135° in relation to the first fastening leg, and
- a supporting leg (10), running at an angle of 110° to 160° in relation to the second, outwardly facing fastening leg (8).

## Revendications

1. Utilisation d'une tôle dont au moins une face est recouverte par une feuille (15) en matière synthétique d'une épaisseur de 0,25 à 2 mm comme support de cellules solaires ou de modules (6) de cellules solaires, la feuille (15) en matière synthétique utilisée pour recouvrir la tôle de support étant constituée principalement d'un polymère constitué du monomère éthylène et d'au moins un comonomère sélectionné dans l'ensemble constitué des esters de vinyle et d'un acide (alkyle en C₂ à C₃)carboxylique et d' esters d'alkyle en C₁ à C₄ et de l'acide acrylique.

2. Utilisation selon la revendication 1, **caractérisée en ce que** comme feuille (15) de matière synthétique, on utilise une bande d'étanchéité de toiture.

3. Utilisation selon l'une des revendications 1 ou 2, **caractérisée en ce que** les cellules solaires ou les modules (6) de cellules solaires sont dotés sur leur dos d'un revêtement de matière synthétique, le revêtement en matière synthétique des cellules solaires ou des modules (6) de cellules solaires pouvant être soudé à la feuille en matière synthétique de couverture de la tôle de support.

4. Utilisation selon l'une des revendications 1 à 3, **caractérisée en ce que** le recouvrement des cellules solaires ou des modules de cellules solaires par application d'une feuille en matière synthétique sur la tôle de support s'effectue par soudage thermique et en particulier par soudage au gaz chaud.

5. Module (4) de montage de cellules solaires, qui présente au moins une cellule solaire ou au moins un module (6) de cellules solaires ainsi qu'un bâti (5) en tôle profilée,
**caractérisé en ce que**
au moins une face de la tôle profilée utilisée pour le bâti est recouverte par une feuille (15) de matière synthétique,
la feuille (15) de matière synthétique est constituée principalement d'un polymère constitué du monomère éthylène et d'au moins un comonomère sélectionné dans l'ensemble constitué des esters de vinyle et d'un acide (alkyle en C₂ à C₃)carboxylique et d' esters d'alkyle en C₁ à C₄ et de l'acide acrylique,
**en ce que** la feuille (15) de matière synthétique présente une épaisseur de 0,25 à 2 mm et
**en ce que** la cellule solaire ou le module de cellules solaires sont appliqués sur la feuille (15) de matière synthétique constituée du polymère.

6. Module (4) de montage de cellules solaires selon la revendication 5, **caractérisé en ce que** vu en coupe transversale, le bâti (5) en tôle profilée présente :
une première aile de fixation (7) tournée vers l'extérieur,
une deuxième aile de fixation (8) tournée vers l'extérieur,
une aile de liaison (9) qui forme un angle de 90° à 135° avec la première aile de fixation et
une aile de support (10) qui forme un angle de 110° à 160° avec la deuxième aile de fixation (8) tournée vers l'extérieur.
